# EUROPEAN PATENT APPLICATION

(11) **EP 4 669 035 A1**
(43) Date of publication of application: **24.12.2025**
(21) Application number: 24218053.7
(22) Date of filing: 06.12.2024
(51) Int. Cl.: H05K 1/14, H05K 1/18, H05K 3/36, H05K 1/02

(54) **STACKED CIRCUIT BOARD ASSEMBLY AND MOTOR DRIVER**

(30) Priority: 21.06.2024 CN 202410810825
(71) Applicant: Delta Electronics, Inc., Taoyuan City 333 (TW)
(72) Inventor: KUO, Wen-Hao, 333 Taoyuan City (TW); LEE, Chi-Yu, 333 Taoyuan City (TW)
(74) Representative: Riccardi, Elisa

(57) **Abstract**

A stacked circuit board assembly includes a first circuit board, a second circuit board alongside the first circuit board, and a third circuit board disposed between the first and second circuit boards. The first circuit board includes a first electrical contact, and the second circuit board includes a second electrical contact. The third circuit board includes a substrate, a third electrical contact, a fourth electrical contact and a conductive connection structure. The third and fourth electrical contacts are disposed on two opposite surfaces of the substrate, respectively, and are attached to the first and second electrical contacts, respectively. The conductive connection structure connects the third electrical contact to the fourth electrical contact.

## Description

### BACKGROUND

### Technical Field

The present disclosure relates to a stacked circuit board assembly and a motor driver.

### Description of Related Art

Due to space constraints or other considerations, some electronic products include stacked circuit boards. Conventionally, in order to connect the stacked circuit boards, the circuit boards are provided with male/female electrical connectors. However, said approach has several drawbacks, including: (1) the electrical connectors take up considerable space, and therefore the overall size of the stacked circuit boards cannot be further reduced; (2) the material cost of the electrical connectors causes the total cost of the product to increase; (3) the circuit boards must be manually assembled, making the production process time-consuming and labor-intensive.

### SUMMARY

In view of the foregoing, one of the objects of the present disclosure is to provide an improved stacked circuit board assembly to resolve the issues mentioned above.

To achieve the objective stated above, in accordance with an embodiment of the present disclosure, a stacked circuit board assembly includes a first circuit board, a second circuit board arranged alongside the first circuit board, and a third circuit board disposed between the first and second circuit boards. The first circuit board includes a first electrical contact, and the second circuit board includes a second electrical contact. The third circuit board includes a substrate, a third electrical contact, a fourth electrical contact and a conductive connection structure. The third and fourth electrical contacts are disposed on two opposite surfaces of the substrate, respectively. The third and fourth electrical contacts are attached to the first and second electrical contacts, respectively. The conductive connection structure connects the third electrical contact to the fourth electrical contact.

In one or more embodiments of the present disclosure, the first circuit board further includes at least one electronic component projecting from a surface of the first circuit board. The substrate of the third circuit board has at least one opening configured to receive the electronic component.

In one or more embodiments of the present disclosure, the at least one electronic component and the at least one opening are plural in number. Each of the electronic components is disposed in one of the openings.

In one or more embodiments of the present disclosure, the substrate of the third circuit board includes an extending structure extending between the openings. The third electrical contact, the fourth electrical contact and the conductive connection structure are disposed on the extending structure.

In one or more embodiments of the present disclosure, the first circuit board further includes an electronic component and a thermal pad. The thermal pad covers a region of a surface of the first circuit board. The electronic component and the first electrical contact are positioned outside the region.

In one or more embodiments of the present disclosure, the first circuit board further includes a power electronic component connected to the first electrical contact, and the second circuit board further includes a control component connected to the second electrical contact.

In one or more embodiments of the present disclosure, the first circuit board further includes an aluminum substrate. The power electronic component and the first electrical contact are disposed on the aluminum substrate.

In one or more embodiments of the present disclosure, the second circuit board further includes a second substrate and a post. The post and the second electrical contact are disposed on the second substrate. The post is configured to be joined with an external component.

In one or more embodiments of the present disclosure, the first circuit board and the substrate of the third circuit board each have a notch, and the post is disposed in the notch.

In one or more embodiments of the present disclosure, the conductive connection structure penetrates through the substrate or extends along a lateral surface of the substrate.

In accordance with an embodiment of the present disclosure, a motor driver includes the stacked circuit board assembly described above, in which the first circuit board is a power board and the second circuit board is a control board.

In sum, unlike the conventional technique of utilizing male and female electrical connectors to connect stacked circuit boards, the stacked circuit board assembly of the present disclosure is provided a third circuit board which is positioned between a first circuit board and a second circuit boards and electrically connecting the first and second circuit boards. The third circuit board is provided with electrical contacts on its two opposite sides, and the electrical contacts on the two opposite sides are connected by a conductive connection structure. The first and second circuit boards are also provided with electrical contacts. The electrical contacts of the first and second circuit boards are each attached to a respective electrical contact of the third circuit board. By this arrangement, the stacked circuit board assembly of the present disclosure can have reduced size and reduced material cost. Moreover, production of the stacked circuit board assembly can be automated (e.g., the second and third circuit boards can be joined with the first circuit board by automated SMT equipment), resulting in an improvement in productivity.

### BRIEF DESCRIPTION OF THE DRAWINGS

To make the objectives, features, advantages, and embodiments of the present disclosure, including those mentioned above and others, more comprehensible, descriptions of the accompanying drawings are provided as follows.
Fig. 1 illustrates an assembled view of a stacked circuit board assembly in accordance with an embodiment of the present disclosure;
Fig. 2 illustrates an exploded view of the stacked circuit board assembly shown in Fig. 1;
Fig. 3 illustrates a schematic sectional view of the stacked circuit board assembly shown in Fig. 1 taken along the line segment 3-3';
Fig. 4 illustrates a schematic sectional view of a stacked circuit board assembly in accordance with another embodiment of the present disclosure; and
Fig. 5 illustrates an isometric view of a stacked circuit board assembly in accordance with another embodiment of the present disclosure.

### DETAILED DESCRIPTION

For the completeness of the description of the present disclosure, reference is made to the accompanying drawings and the various embodiments described below. Various features in the drawings are not drawn to scale and are provided for illustration purposes only. To provide full understanding of the present disclosure, various practical details will be explained in the following descriptions. However, a person with an ordinary skill in relevant art should realize that the present disclosure can be implemented without one or more of the practical details. Therefore, the present disclosure is not to be limited by these details.

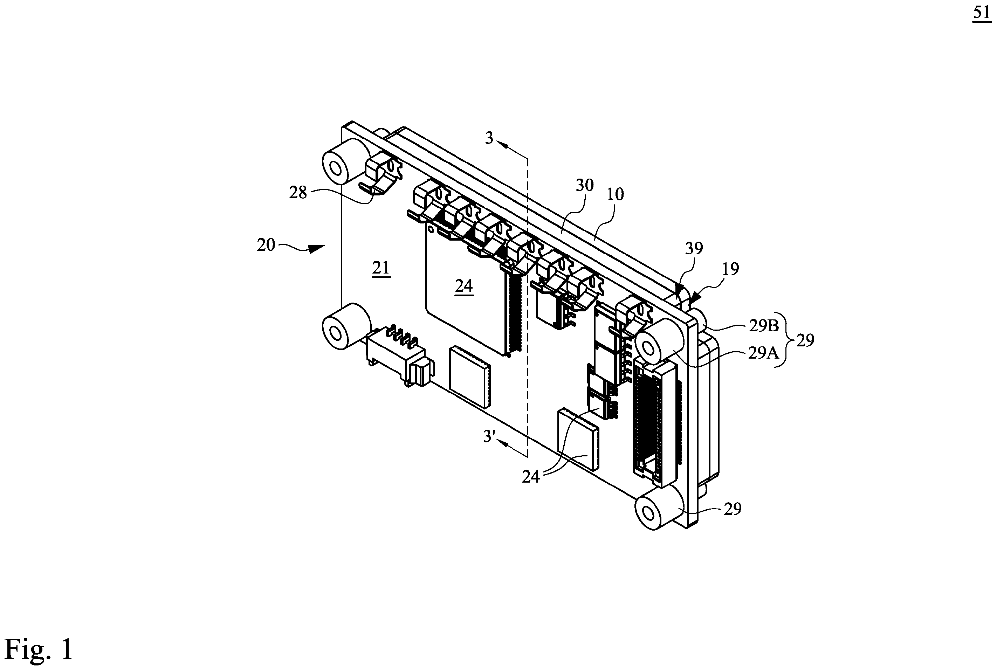

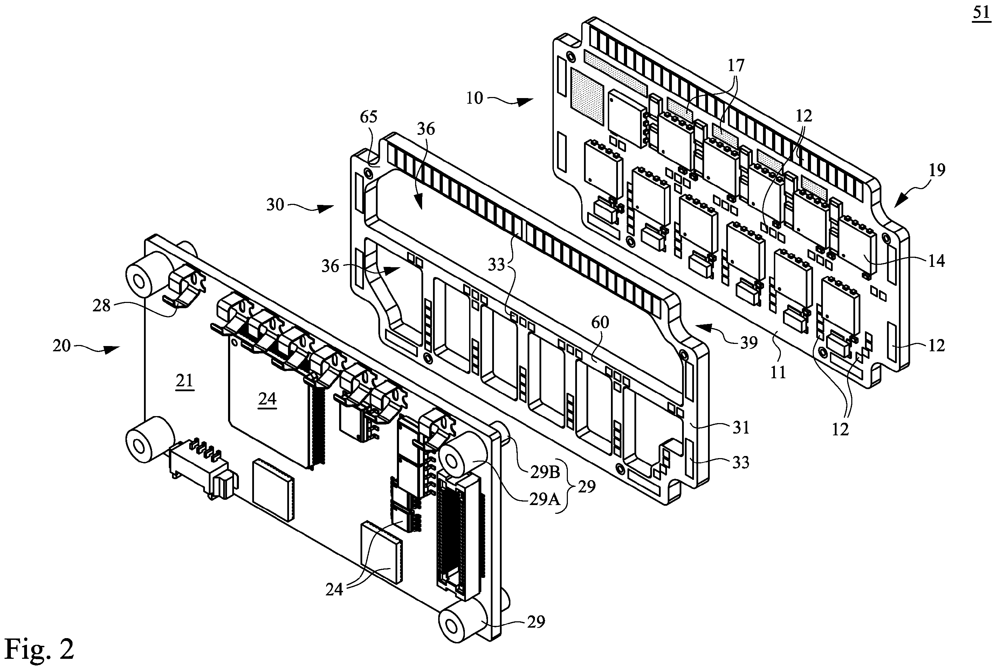

Reference is made to Figs. 1 and 2. Fig. 1 illustrates an assembled view of a stacked circuit board assembly 51 in accordance with an embodiment of the present disclosure. Fig. 2 illustrates an exploded view of the stacked circuit board assembly 51 shown in Fig. 1. The stacked circuit board assembly 51 includes a first circuit board 10, a second circuit board 20 and a third circuit board 30 in a stack arrangement. Specifically, the second circuit board 20 is arranged alongside the first circuit board 10 and is spaced apart from the first circuit board 10. The third circuit board 30 is disposed between the first circuit board 10 and the second circuit board 20. The third circuit board 30 is configured to electrically connect the first circuit board 10 and the second circuit board 20.

The third circuit board 30 has a first side facing the first circuit board 10 and a second side facing the second circuit board 20. The third circuit board 30 is provided with electrical contacts on both the first side and the second side, and the electrical contacts on the first and second sides are connected by a conductive connection structure. The first circuit board 10 and the second circuit board 20 are also provided with electrical contacts. The electrical contacts of the first circuit board 10 and the second circuit board 20 are each attached to a respective electrical contact of the third circuit board 30. As a result, electrical connection between the first circuit board 10 and the second circuit board 20 is created, such that signals can be transmitted between the first circuit board 10 and the second circuit board 20.

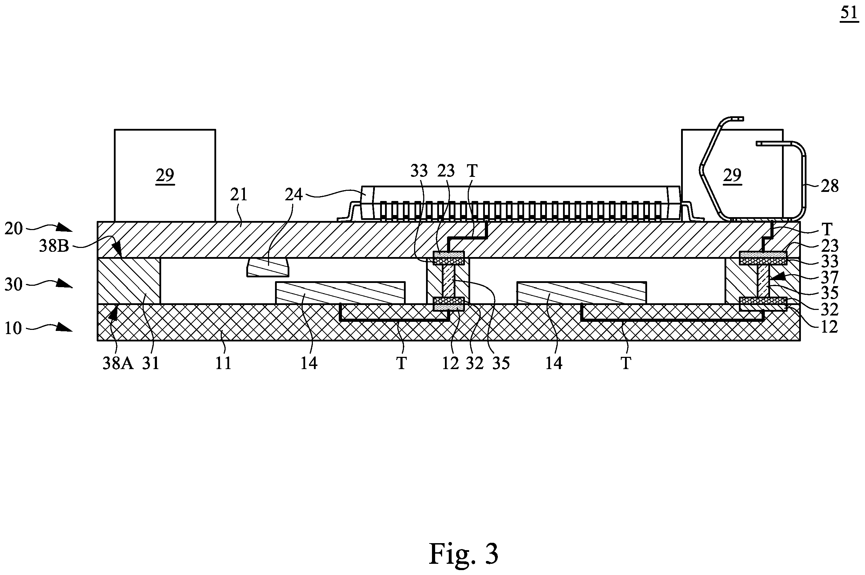

Reference is made additionally to Fig. 3. Fig. 3 illustrates a schematic sectional view of the stacked circuit board assembly 51 shown in Fig. 1 taken along the line segment 3-3'. As shown in Figs. 1-3, the first circuit board 10 includes a first substrate 11 and at least one first electrical contact 12. The first electrical contact 12 is disposed on a surface of the first substrate 11 and is substantially flush with the surface of the first substrate 11. The second circuit board 20 includes a second substrate 21 and at least one second electrical contact 23. The second electrical contact 23 is disposed on a surface of the second substrate 21 and is substantially flush with the surface of the second substrate 21. The first electrical contact 12 and the second electrical contact 23 face the third circuit board 30.

As shown in Figs. 1-3, the first circuit board 10 may further include at least one first electronic component 14. The first electronic component 14 is disposed on a surface of the first substrate 11 and projects from the surface of the first substrate 11. The second circuit board 20 may further include at least one second electronic component 24. The second electronic component 24 is disposed on a surface of the second substrate 21 and projects from the surface of the second substrate 21. In some embodiments, the first electronic component 14 and the second electronic component 24 are affixed to the first substrate 11 and the second substrate 21, respectively, by means of soldering.

As shown in Figs. 1-3, in some embodiments, part or all of the at least one first electrical contact 12 is electrically connected to the at least one first electronic component 14 by a conductive trace T (drawn schematically) arranged on an outer surface of the first substrate 11 or in the interior of the first substrate 11. In some embodiments, part or all of the at least one second electrical contact 23 is electrically connected to the at least one second electronic component 24 by a conductive trace T (drawn schematically) arranged on an outer surface of the second substrate 21 or in the interior of the second substrate 21.

As shown in Figs. 1-3, the third circuit board 30 includes a third substrate 31, at least one third electrical contact 32 and at least one fourth electrical contact 33. The third substrate 31 has two opposite surfaces 38A and 38B. The two surfaces 38A and 38B face the first circuit board 10 and the second circuit board 20, respectively. The third electrical contact 32 is disposed on the surface 38A of the third substrate 31 and is substantially flush with the surface 38A. The fourth electrical contact 33 is disposed on the surface 38B of the third substrate 31 and is substantially flush with the surface 38B. Each third electrical contact 32 is attached to a respective first electrical contact 12 of the first circuit board 10, and each fourth electrical contact 33 is attached to a respective second electrical contact 23 of the second circuit board 20.

In some embodiments, the first electrical contact 12, the second electrical contact 23, the third electrical contact 32 and the fourth electrical contact 33 include conductive pads, which can be made of Au, Ag, Cu or other suitable electrically conductive materials. In some embodiments, the conductive pads have generally rectangular shapes.

It is noted that the expression "X is attached to Y" used herein, in which elements X and Y may be electrical contacts, intends to specify a connection relationship where element X can be either directly attached to element Y (i.e., element X makes contact with element Y) or indirectly attached to element Y via an additional conductive element such as solder, conductive paste, conductive gasket, etc.

As shown in Figs. 1-3, the third circuit board 30 further includes at least one conductive connection structure 35 disposed on the third substrate 31. Each conductive connection structure 35 is connected between a pair of third electrical contact 32 and fourth electrical contact 33 to make the pair of third electrical contact 32 and fourth electrical contact 33 electrically connected. In some embodiments, the stacked circuit board assembly 51 includes an equal number of the first electrical contact 12, the second electrical contact 23, the third electrical contact 32, the fourth electrical contact 33, and the conductive connection structure 35.

Unlike the conventional technique of utilizing male and female electrical connectors to connect stacked circuit boards, the stacked circuit board assembly 51 of the present disclosure includes the third circuit board 30 interposed between the first circuit board 10 and the second circuit board 20 to electrically connect the first circuit board 10 to the second circuit board 20. By this arrangement, the stacked circuit board assembly 51 can have reduced size and reduced material cost. Moreover, production of the stacked circuit board assembly 51 can be automated (e.g., the second circuit board 20 and the third circuit board 30 can be joined with the first circuit board 10 by automated SMT (surface-mount technology) equipment), resulting in an improvement in productivity.

In some embodiments, a method of manufacturing the stacked circuit board assembly 51 may include the following steps: (1) affixing the at least one first electronic component 14 to one or more predetermined locations on the first substrate 11 to create the first circuit board 10; (2) aligning the third electrical contact 32 of the third circuit board 30 with the first electrical contact 12 of the first circuit board 10, and subsequently affixing the third electrical contact 32 to the first electrical contact 12; (3) affixing the at least one second electronic component 24 to one or more predetermined locations on the second substrate 21 to create the second circuit board 20; (4) aligning the second electrical contact 23 of the second circuit board 20 with the fourth electrical contact 33 of the third circuit board 30, and subsequently affixing the second electrical contact 23 to the fourth electrical contact 33. In some embodiments, steps (1)-(4) can be performed by automated SMT equipment.

In some embodiments, the stacked circuit board assembly 51 can be included in a motor driver. In some embodiments, the first circuit board 10 of the stacked circuit board assembly 51 can be a power board of the motor driver. The at least one first electronic component 14 of the first circuit board 10 can include at least one power electronic component, which can include at least one of a current feedback resistor or a transistor (e.g., MOSFET). In some embodiments, the second circuit board 20 of the stacked circuit board assembly 51 can be a control board of the motor driver. The at least one second electronic component 24 of the second circuit board 20 can include at least one control component, which can include at least one of a microcontroller unit (MCU), a driver IC, or a sensor. In some embodiments, the power board can receive signals from the control board, amplifies the received signals, and then outputs the amplified signals, so as to control the operation of an electric motor connected to the motor driver.

In the aforementioned embodiment, the temperature of the power board can rise easily since the power board consumes more power. To help the power board dissipate heat, as shown in Fig. 2, in some embodiments, the first circuit board 10 further includes at least one thermal pad 17. The thermal pad 17 covers a region of a surface of the first substrate 11. The first electronic component 14 and the first electrical contact 12 are positioned outside the region covered by the thermal pad 17. In other words, the thermal pad 17 can be provided at any location on the surface of the first substrate 11 that is not occupied by the first electronic component 14, the first electrical contact 12, or the conductive traces of the first substrate 11. The thermal pad 17 may include Au, Ag, Cu, Al, other suitable thermally conductive materials, or any combination thereof.

In some embodiments, if the second circuit board 20 needs extra help with heat removal, the second circuit board 20 may also include at least one thermal pad 17. The thermal pad 17 can be provided at any location on the surface of the second substrate 21 that is not occupied by the second electronic component 24, the second electrical contact 23, or the conductive traces of the second substrate 21.

As mentioned above, the stacked circuit board assembly 51 of the present disclosure includes the third circuit board 30 with electrical contacts to replace the electrical connectors found in conventional stacked circuit board assemblies. Electrical contacts are smaller in size compared to electrical connectors, which can not only allow the size of the stacked circuit board assembly 51 to be reduced, but also create more space on the outer surface of the first circuit board 10 and/or the second circuit board 20 for placing the thermal pad 17 to facilitate cooling of the first circuit board 10 and/or the second circuit board 20.

In some embodiments, the first substrate 11 of the first circuit board 10 is an aluminum substrate (e.g., a PCB with an aluminum core) to facilitate cooling of the first circuit board 10. In some embodiments, the second substrate 21 of the second circuit board 20 can also be an aluminum substrate.

In some embodiments, the stacked circuit board assembly 51 can be included in other high-power devices, such as a power supply.

In other embodiments, if the first circuit board 10 and the second circuit board 20 do not need extra help with heat removal (e.g., when the stacked circuit board assembly 51 does not include any power electronic component), the first substrate 11 of the first circuit board 10 and the second substrate 21 of the second circuit board 20 may be non-aluminum substrates (e.g., a PCB with a core made of composite material, such as FR-4 PCB).

As shown in Figs. 1-3, in some embodiments, the second circuit board 20 further includes at least one post 29. The post 29 is disposed on the second substrate 21 and projects from a surface of the second substrate 21. The post 29 is configured to be joined with an external component (e.g., a heatsink or an additional circuit board). For example, the external component can be affixed to the post 29 via a screw or other types of fasteners.

As shown in Figs. 1-3, in some embodiments, the post 29 is provided at at least one corner of the second substrate 21. In some embodiments, the second substrate 21 has four corners and each corner is provided with the post 29. In some embodiments, the post 29 can include copper or other suitable materials.

As shown in Figs. 1-3, in some embodiments, the post 29 penetrates through the second substrate 21. Specifically, each post 29 may include two terminal portions 29A and 29B located on opposite sides of the second substrate 21. In some embodiments, the first substrate 11 of the first circuit board 10 has at least one notch 19, and the third substrate 31 of the third circuit board 30 has at least one notch 39. The notches 19 and 39 are provided at corresponding locations. The terminal portion 29B of the post 29 can be disposed in the notches 19 and 39, such that the terminal portion 29B of the post 29 is not covered by the first circuit board 10 and the third circuit board 30. By this arrangement, the two terminal portions 29A and 29B of the post 29 can both be used to connect external components. In some embodiments, the first substrate 21/the third substrate 31 has four corners and each corner is provided with the notch 19/the notch 39.

As shown in Figs. 1-3, in some embodiments, the second circuit board 20 further includes at least one conductive spring contact 28. The conductive spring contact 28 is disposed on a surface of the second substrate 21 away from the third circuit board 30. When a fourth circuit board (not depicted in Figs. 1-3) is affixed to the post 29, the conductive spring contact 28 can be electrically connected to the fourth circuit board. In some embodiments, the second circuit board 20 includes a plurality of conductive spring contacts 28 arranged along an edge of the second substrate 21.

As shown in Figs. 1-3, in some embodiments, part or all of the at least one second electrical contact 23 is electrically connected to the at least one conductive spring contact 28 by a conductive trace T (drawn schematically) arranged on an outer surface of the second substrate 21 or in the interior of the second substrate 21, so as to enable signal transmission between the fourth circuit board and the first circuit board 10. In other embodiments, the conductive spring contact 28 can be electrically connected to the second electronic component 24 by a conductive trace of the second substrate 21, so as to enable signal transmission between the fourth circuit board and the second electronic component 24.

As shown in Figs. 1-3, in some embodiments, the conductive connection structure 35 is provided in the interior of the third substrate 31, and the conductive connection structure 35 penetrates through the third substrate 31. In some embodiments, the third substrate 31 further has at least one thru-hole 37. The thru-hole 37 extends from the surface 38A of the third substrate 31 to the surface 38B. The thru-hole 37 is filled by a conductive material (e.g., Au, Ag, Cu or other suitable metallic materials) to create the conductive connection structure 35.

As shown in Figs. 1-3, in some embodiments, the third substrate 31 further has at least one opening 36. The at least one opening 36 is configured to receive the at least one the first electronic component 14 of the first circuit board 10 or the at least one second electronic component 24 of the second circuit board 20. By this arrangement, the first circuit board 10 and the second circuit board 20 can be brought closer to each other, and the thickness of the stacked circuit board assembly 51 is reduced accordingly.

As shown in Figs. 1-3, in some embodiments, the opening 36 penetrates through the third substrate 31. In some embodiments, the third substrate 31 has a plurality of openings 36. The first circuit board 10 can include a plurality of first electronic components 14. Each of the first electronic components 14 is disposed in one of the openings 36.

As shown in Figs. 1-3, in some embodiments, the third substrate 31 of the third circuit board 30 includes an extending structure 60 extending between the openings 36. In some embodiments, at least part of the third electrical contact 32, the fourth electrical contact 33 and the conductive connection structure 35 are disposed on the extending structure 60. In some embodiments, the third substrate 31 of the third circuit board 30 further includes a frame structure 65. The frame structure 65 is a ring-shaped structure. The frame structure 65 extends generally along a periphery of the first substrate 11 of the first circuit board 10 and along a periphery of the second substrate 21 of the second circuit board 20. The extending structure 60 is connected to the frame structure 65 and divides a central hollow portion of the frame structure 65 into the plurality of openings 36. In some embodiments, at least part of the third electrical contact 32, the fourth electrical contact 33 and the conductive connection structure 35 are disposed on the frame structure 65.

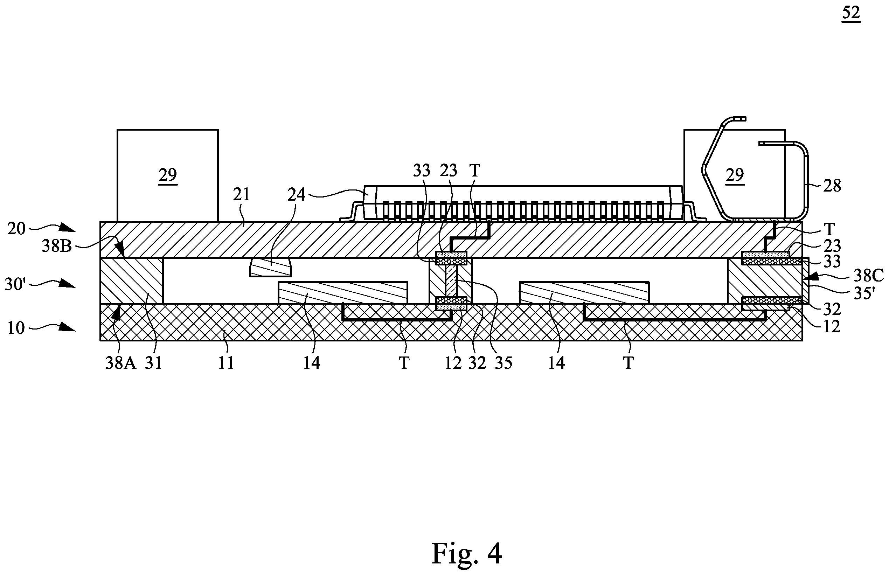

Reference is made to Fig. 4. Fig. 4 illustrates a schematic sectional view of a stacked circuit board assembly 52 in accordance with another embodiment of the present disclosure. The present embodiment differs from the embodiments described above in that the conductive connection structure 35' of the third circuit board 30' extends along a lateral surface 38C of the third substrate 31 (the lateral surface 38C is connected between the two surfaces 38A and 38B), and the two ends of the conductive connection structure 35' are joined with the third electrical contact 32 and the fourth electrical contact 33, respectively.

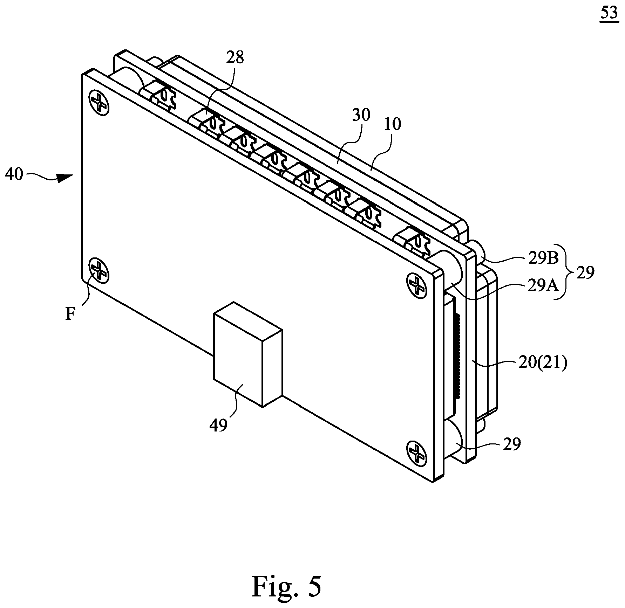

Reference is made to Fig. 5. Fig. 5 illustrates an isometric view of a stacked circuit board assembly 53 in accordance with another embodiment of the present disclosure. Compared to the embodiments described above, the stacked circuit board assembly 53 of the present embodiment further includes a fourth circuit board 40. The fourth circuit board 40 is disposed on a side of the second circuit board 20 away from the third circuit board 30. In some embodiments, the fourth circuit board 40 may be affixed to the at least one post 29 via at least one fastener F. For example, the fastener F can be fixedly inserted into a hole of the post 29 to secure the fourth circuit board 40. In some embodiments, the fourth circuit board 40 can be attached to the conductive spring contact 28 of the second circuit board 20, such that signals can be transmitted between the fourth circuit board 40 and the first circuit board 10 and/or the second circuit board 20. In some embodiment, the fourth circuit board 40 can include an electrical connector 49. The electrical connector 49 is configured to be connected to an external device via a cable. In embodiments where the stacked circuit board assembly 53 is included in a motor driver, the electrical connector 49 may be connected to an electric motor.

In sum, unlike the conventional technique of utilizing male and female electrical connectors to connect stacked circuit boards, the stacked circuit board assembly of the present disclosure is provided a third circuit board which is positioned between a first circuit board and a second circuit boards and electrically connecting the first and second circuit boards. The third circuit board is provided with electrical contacts on its two opposite sides, and the electrical contacts on the two opposite sides are connected by a conductive connection structure. The first and second circuit boards are also provided with electrical contacts. The electrical contacts of the first and second circuit boards are each attached to a respective electrical contact of the third circuit board. By this arrangement, the stacked circuit board assembly of the present disclosure can have reduced size and reduced material cost. Moreover, production of the stacked circuit board assembly can be automated (e.g., the second and third circuit boards can be joined with the first circuit board by automated SMT equipment), resulting in an improvement in productivity.

## Claims

1. A stacked circuit board assembly (51, 52, 53), **characterized by** comprising:
a first circuit board (10) comprising a first electrical contact (12);
a second circuit board (20) arranged alongside the first circuit board (10) and comprising a second electrical contact (23); and
a third circuit board (30, 30') disposed between the first circuit board (10) and the second circuit board (20), the third circuit board comprising a substrate (31), a third electrical contact (32), a fourth electrical contact (33) and a conductive connection structure (35, 35'), wherein the third electrical contact (32) and the fourth electrical contact (33) are disposed on two opposite surfaces of the substrate (31), respectively, and the third electrical contact (32) and the fourth electrical contact (33) are attached to the first electrical contact (12) of the first circuit board (10) and the second electrical contact (23) of the second circuit board (20), respectively, wherein the conductive connection structure (35, 35') connects the third electrical contact (32) to the fourth electrical contact (33).

2. The stacked circuit board assembly of claim 1, **characterized in that** the first circuit board (10) further comprises at least one electronic component (14) projecting from a surface of the first circuit board (10), wherein the substrate (31) of the third circuit board (30, 30') has at least one opening (36) configured to receive the at least one electronic component (14).

3. The stacked circuit board assembly of claim 2, **characterized in that** the at least one electronic component (14) and the at least one opening (36) are plural in number, and each of the electronic components (14) is disposed in one of the openings (36).

4. The stacked circuit board assembly of claim 3, **characterized in that** the substrate (31) of the third circuit board (30, 30') comprises an extending structure (60) extending between the openings (36), wherein the third electrical contact (32), the fourth electrical contact (33) and the conductive connection structure (35, 35') are disposed on the extending structure (60).

5. The stacked circuit board assembly of claim 1, **characterized in that** the first circuit board (10) further comprises an electronic component (14) and a thermal pad (17), the thermal pad (17) covers a region of a surface of the first circuit board (10), the electronic component (14) and the first electrical contact (12) are positioned outside the region.

6. The stacked circuit board assembly of claim 1, **characterized in that** the first circuit board (10) further comprises a power electronic component (14) connected to the first electrical contact (12), and the second circuit board (20) further comprises a control component (24) connected to the second electrical contact (23).

7. The stacked circuit board assembly of claim 6, **characterized in that** the first circuit board (10) further comprises an aluminum substrate (11), the power electronic component (14) and the first electrical contact (12) are disposed on the aluminum substrate (11).

8. The stacked circuit board assembly of any preceding claim, **characterized in that** the second circuit board (20) further comprises a second substrate (21) and a post (29), the post (29) and the second electrical contact (23) are disposed on the second substrate (21), and the post (29) is configured to be joined with an external component.

9. The stacked circuit board assembly of claim 8, **characterized in that** the first circuit board (10) and the substrate (31) of the third circuit board (30, 30') each have a notch (19, 39), and the post (29) is disposed in the notch (19, 39).

10. The stacked circuit board assembly of any preceding claim, **characterized in that** the conductive connection structure (35) penetrates through the substrate (31).

11. The stacked circuit board assembly of any of claims 1-9, **characterized in that** the conductive connection structure (35') extends along a lateral surface of the substrate (31).

12. A motor driver, **characterized by** comprising:
the stacked circuit board assembly (51, 52, 53) of any preceding claim, wherein the first circuit board (10) is a power board, and the second circuit board (20) is a control board.
